# EUROPÄISCHE PATENTSCHRIFT

(11) **EP 4 306 971 B1**
(45) Veröffentlichungstag und Bekanntmachung des Hinweises auf die Patenterteilung: **05.03.2025**
(21) Anmeldenummer: 23183269.2
(22) Anmeldetag: 04.07.2023
(51) Int. Cl.: G01R 27/18

(54) **VERFAHREN UND ELEKTRISCHE SCHALTUNGSANORDNUNG ZUR BESTIMMUNG EINES ZWEIG-ISOLATIONSWIDERSTANDS UND EINER ZWEIG-ABLEITKAPAZITÄT IN EINEM UNGEERDETEN STROMVERSORGUNGSSYSTEM**
METHOD AND ELECTRICAL CIRCUIT ARRANGEMENT FOR DETERMINING BRANCH ISOLATION RESISTANCE AND BRANCH DISCHARGE CAPACITANCE IN AN UNEARTHED POWER SUPPLY SYSTEM
PROCÉDÉ ET CIRCUIT ÉLECTRIQUE POUR DÉTERMINER UNE RÉSISTANCE D'ISOLATION DE BRANCHES ET UNE CAPACITÉ DE DÉRIVATION DE BRANCHES DANS UN SYSTÈME D'ALIMENTATION ÉLECTRIQUE NON MIS À LA TERRE

(30) Priorität: 11.07.2022 DE 102022117233
(43) Veröffentlichungstag der Anmeldung: 17.01.2024
(73) Patentinhaber: Bender GmbH & Co. KG, 35305 Grünberg (DE)
(72) Erfinder: BECKER, Pascal, 35305 Grünberg (DE)
(74) Vertreter: advotec.

(56) Entgegenhaltungen:
- EP-A2- 0 593 007
- DE-A1- 102011 108 716
- US-A- 5 365 179

## Beschreibung

Die Erfindung betrifft ein Verfahren und eine elektrische Schaltungsanordnung zur Bestimmung eines Zweig-Isolationswiderstands und einer Zweig-Ableitkapazität eines zu überwachenden Leitungszweiges in einem verzweigten, ungeerdeten Stromversorgungssystem mit aktiven Leitern mit Erzeugen einer Messspannung mittels einer steuerbaren Messspannungsquelle, Einspeisen der Messspannung an zentraler Stelle des Stromversorgungssystems mittels einer Ankoppelschaltung jeweils in die aktiven Leiter und mit Erfassen eines durch die Messspannung bewirkten Differenzstroms in dem zu überwachenden Leitungszweig mittels eines Stromsensors.

Bei erhöhten Anforderungen an die Betriebs-, Brand- und Berührungssicherheit elektrischer Anlagen kommt die Netzform eines ungeerdeten Stromversorgungssystems zum Einsatz, die auch als isoliertes Netz (isolé terre - IT) oder als IT-(Stromversorgungs-)System bezeichnet wird. Bei dieser Art des Stromversorgungssystems sind die aktiven Teile von dem Erdpotential - gegenüber Erde - getrennt. Der Vorteil dieser Netze liegt darin, dass bei einem Isolationsfehler, wie beispielsweise einem Erdschluss oder einem Körperschluss, die Funktion der angeschlossenen elektrischen Verbraucher nicht beeinträchtigt wird, da sich wegen des im Idealfall unendlich großen Impedanzwertes zwischen einem aktiven Leiter des Netzes und Erde kein geschlossener Stromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter eine Fehlerschleife entstünde und der dabei fließende Fehlerstrom in Verbindung mit einer Überstromschutzeinrichtung eine Abschaltung der Anlage mit Betriebsstillstand zur Folge hätte.

Unter der Voraussetzung, dass der Isolationszustand des ungeerdeten Stromversorgungssysteme kontinuierlich von einem Isolationsüberwachungsgerät überwacht wird, kann das ungeerdete Stromversorgungssystem auch bei einem aufgetretenen ersten Fehler ohne vorgeschriebene Zeitlimitierung weiter betrieben werden.

Zur Überwachung des Isolationswiderstands werden Isolationsüberwachungsgeräte eingesetzt. Aus dem Stand der Technik bekannte Isolationsüberwachungsgeräte nach der Produktnorm IEC 61557-8 bestimmen den (Gesamt-)Isolationswiderstand des gesamten IT-Systems gegen Erde. Das Isolationsüberwachungsgerät wird zwischen den aktiven Leitern einerseits und Erde andererseits angeschlossen und überlagert dem Netz ein Messsignal. Bei Auftreten eines Isolationsfehlers schließt sich der Messkreis zwischen Netz und Erde über den Isolationsfehler, sodass sich ein dem Isolationsfehler entsprechender Messstrom einstellt. Dieser Messstrom verursacht an einem Messwiderstand in dem Isolationsüberwachungsgerät einen entsprechenden Spannungsabfall, der von der Elektronik ausgewertet wird und bei Überschreiten eines voreinstellbaren Grenzwertes zu einer Alarmmeldung führt.

Normgemäß ausgeführte Isolationsüberwachungsgeräte berücksichtigen dabei symmetrisch auf alle aktiven Leiter verteilte ohmsche Ableitungen als Isolationsfehler genauso wie unsymmetrisch, beispielsweise an einem einzelnen aktiven Leiter auftretende Isolationsfehler.

Auf dem Markt verfügbare Isolationsüberwachungsgeräte besitzen neben der Bestimmung des Isolationswiderstands zusätzlich die Funktionalität, die (Gesamt-)(Netz-)Ableitkapazität des ungeerdeten Stromversorgungssystems gegen Erde zu bestimmen. Analog zu dem Isolationswiderstand, welcher den ohmschen Anteil der Ableitimpedanz darstellt, stellt die Ableitkapazität den kapazitiven Anteil der Ableitimpedanz gegen Erde dar. Die (Gesamt-)Ableitkapazität ist dabei die Summe aller Ableitkapazitäten in dem gesamten IT-Systems gegen Erde.

Typischerweise erfolgt also die Bestimmung des Isolationswiderstands und gegebenenfalls der Ableitkapazität mit einem zentral angeordneten Isolationsüberwachungsgerät und bezieht sich auf das gesamte ungeerdete Stromversorgungssystem.

Um differenziertere Aussagen über den Isolationszustand des verzweigten, ungeerdeten Stromversorgungssystems machen zu können und Isolationsfehler gegebenenfalls schneller lokalisieren zu können, ist es daher anzustreben, selektiv für einen bestimmten Leitungszweig (Leitungsabgang) des Stromversorgungssystems Informationen über den in diesem Leitungszweig wirksamen Zweig-Isolationswiderstand bzw. die Zweig-Ableitkapazität zur erhalten.

Aus dem Stand der Technik sind verschiedene Lösungen zur Ermittlung eines Teil-Isolationswiderstands und einer Teil-Ableitkapazität bekannt. So zeigt die Patentschrift DE10 2017 217 473 B3 ein Verfahren, welches zur Bestimmung eines Teil-Isolationswiderstands und einer Teil-Netzableitkapazität eine kontinuierliche, messtechnische Bestimmung des Gesamt-Isolationswiderstands und der Gesamt-Netzableitkapazität durch ein zentral angeordnetes, erweitertes Isolationsüberwachungsgerät voraussetzt.

In der in der Offenlegungsschrift DE10 2014 223 287 A1 offenbarten elektrischen Schutzeinrichtung kann selektiv ein zweiter Fehler in einem Leitungszweig erkannt werden, jedoch erfordert dies einen Kommunikationskanal zwischen der Einspeisestelle und dem in dem zu überwachenden Leitungszweig angeordneten Messstromwandler.

Eine weitere Möglichkeit der Überwachung eines Subsystem-Isolationswiderstands ist in der Offenlegungsschrift DE10 2013 218 836 A1 angegeben, wobei allerdings die Einspeisung eines Messstroms nicht zentral erfolgt, sondern dezentral ein auf den jeweiligen Leitungszweig beschränkter Messstrom fließt. Weiterer Stand der Technik findet sich in den Dokumenten DE102011108716 und EP0593007.

Aus den vorgenannten aus dem Stand der Technik bekannten Lösungen ergeben sich somit die folgenden Anforderungen an eine zweigselektive R/C-Bestimmung, deren Umsetzung jedoch oftmals technisch aufwendige Maßnahmen erfordert:
a) Kommunikation ermittelter Parameter aus anderen Leitungszweigen oder der zentralen Messeinrichtung
b) Spannungsmessung entweder zentral, verbunden mit einer Kommunikation, oder dezentral in jedem Leitungszweig
c) Eine Konfiguration der gesamten Netztopologie in die Auswertegeräte.

Insbesondere ist die Möglichkeit der Kommunikation zwischen einer zentral einspeisenden Messeinrichtung und dem zu überwachenden Leitungszweig oftmals mit erheblichem schaltungstechnischen Aufwand verbunden.

Der vorliegenden Erfindung liegt somit die Aufgabe zugrunde, ein Verfahren und eine elektrische Schaltungsanordnung zur Bestimmung des Zweig-Isolationswiderstands und der Zweig-Ableitkapazität eines Leitungszweiges in einem verzweigten, ungeerdeten Stromversorgungssystem anzugeben, welche nicht auf eine kontinuierliche Kommunikationsverbindung zwischen der zentralen Messspannungs-Einspeisung und einem in dem zu überwachenden Leitungszweig angeordneten Stromsensor angewiesen ist.

Diese Aufgabe wird bezogen auf ein Verfahren in Verbindung mit den Merkmalen des Oberbegriffs in Anspruch 1 durch die kennzeichnenden Merkmale des Anspruchs 1 gelöst.

Die vorliegende Erfindung beruht auf dem Grundgedanken, die erzeugte und zentral eingespeiste Messspannung über jeweils eine Generatorperiode mit einer durch die Frequenzzusammensetzung definierten, charakteristischen Signalform auszubilden, wobei die möglichen Signalformen dem dezentral angeordneten Stromsensor bekannt sind und von diesem interpretiert werden.

Anhand dieser (Frequenz-)Modulation der Messspannung findet von dem zentralen Einspeiseort der Messspannung an den in dem zu überwachenden Leitungszweig angeordneten Stromsensor eine Informationsübertragung statt. Aufgrund dieser Information kann der Stromsensor ermitteln, mit welchem Widerstandwert die Ankoppelschaltung in der jeweiligen Generatorperiode die Messspannung einspeist, ohne dass ein weiterer Kommunikationskanal erforderlich ist.

Der Stromsensor verfügt in Verbindung mit dem Erfassen des durch die Messspannung bewirkten Differenzstroms und in dem Stromsensor hinterlegten Daten über sämtliche Informationen, um den Zweig-Isolationswiderstand und die Zweig-Ableitkapazität zu berechnen.

Die Messspannung wird alternierend über jeweils eine Generatorperiode aus einem ersten Frequenzgemisch und einem zweiten Frequenzgemisch geformt.

Das Einspeisen des ersten Frequenzgemischs erfolgt (während einer Generatorperiode) mittels einer mit einer Schalteinheit umschaltbaren Ankoppelschaltung über einen ersten Ankoppelwiederstand und das Einspeisen des zweiten Frequenzgemischs (in der darauffolgenden Generatorperiode) über einen zweiten Ankoppelwiderstand. Die beiden Frequenzgemische werden jeweils über eine Generatorperiode alternierend eingespeist.

Das Einspeisen der Messspannung mit der Signalform des ersten Frequenzgemischs und damit das Erfassen des dadurch bewirkten und von dem Stromsensor erfassten Differenzstroms ist folglich mit der Aufschaltung des ersten Ankoppelwiderstands verbunden, das Einspeisen des zweiten Frequenzgemischs ist entsprechend mit der Aufschaltung des zweiten Ankoppelwiderstands verbunden.

In einem Datenspeicher des Stromsensors sind der Wert des ersten Ankoppelwiderstands und der Wert des zweiten Ankoppelwiderstands sowie die spektrale Zusammensetzung des ersten Frequenzgemischs und die spektrale Zusammensetzung des zweiten Frequenzgemischs hinterlegt. Durch diese Konfiguration des Stromsensors sind dem Stromsensor neben den beiden Ankoppelwiderständen auch die Amplituden der Spannungsanteile bekannt, aus denen sich die Messspannung zusammensetzt.

Der Stromsensor führt in einer Recheneinheit eine Frequenzanalyse des Differenzstroms über zwei aufeinander folgende Generatorperioden durch, um zu erkennen, welches (der beiden) Frequenzgemisch(e) aktuell eingespeist wird.

Aus der dem Stromsensor bekannten Zuordnung des erkannten Frequenzgemischs zu dem jeweiligen Ankoppelwiderstand wird der aktuell geschaltete Ankoppelwiderstand bestimmt.

Anschließend wird in der Recheneinheit aus dem gemessenen Differenzstrom, der Messspannung, den in dem (ersten und zweiten) Frequenzgemisch enthaltenen Frequenzen und dem (ersten und zweiten) Ankoppelwiderstand der Zweig-Isolationswiderstand und die Zweig-Ableitkapazität in der Recheneinheit berechnet.

Auf der Grundlage der in zwei aufeinanderfolgenden Generatorperioden wirksamen und durch Messung und Konfiguration bekannten Größen lässt sich ein Gleichungssystem aufstellen, aus dem als gesuchte Größen der Zweig-Isolationswiderstand und die Zweig-Ableitkapazität ermittelt wird.

Erfindungsgemäß stehen damit der Recheneinheit des Stromsensors sämtliche Informationen zur Verfügung, aus denen sich unabhängig von den übrigen Netzkomponenten der Zweig-Isolationswiderstand und die Zweig-Ableitkapazität berechnen lässt.

In Verbindung mit einer zentralen Einspeisung der Messspannung werden durch die erfindungsgemäße Frequenzformung der Messspannung und den erfindungsgemäß konfigurierten Stromsensor ohne jegliche weitere Kommunikationsverbindung oder Datenverbindung zu einem zentral angeordneten Isolationsüberwachungsgerät oder zentral angeordneten Prüfgenerator (einer Isolationsfehlersucheinrichtung) der Zweig-Isolationswiderstand und die Zweig-Ableitkapazität bestimmt.

In weiterer Ausgestaltung enthalten das erste Frequenzgemisch und das zweite Frequenzgemisch jeweils mindestens zwei Frequenzen (Frequenzanteile), wobei sich das erste Frequenzgemisch von dem zweiten Frequenzgemisch in mindestens einer Frequenz unterscheidet.

Das erste Frequenzgemisch muss sich von dem zweiten Frequenzgemisch in mindestens einer Frequenz unterscheiden, damit eine eindeutige Zuordnung zu dem jeweils aktuell aufgeschalteten Ankoppelwiderstand gegeben ist. Zum anderen müssen zur Lösung des den Zweig-Isolationswiderstand und die Zweig-Ableitkapazität bestimmenden Gleichungssystems hinreichend viele Gleichungen vorliegen. Dies ist gegeben, wenn zur Formung und alternierenden Einspeisung der Messspannung sowohl das erste Frequenzgemisch als auch das zweite Frequenzgemisch jeweils aus mindestens zwei Frequenzen bestehen.

Um die Robustheit gegen Störeffekte zu erhöhen, ist es auch möglich, die Frequenzgemische aus mehr als zwei Frequenzen zusammenzusetzen.

Weiterhin werden die in den Frequenzgemischen enthaltenen Frequenzen so gewählt, dass deren Perioden als ganzzahliges Vielfaches in der Generatorperiode enthalten sind.

Bevorzugt ist die Messspannung eine Messimpulsspannung eines Isolationsüberwachungsgerätes oder eine Prüfspannung einer Isolationsfehlersucheinrichtung.

In Kombination mit einem zentralen Isolationsüberwachungsgerät oder einer Isolationsfehlersucheinrichtung kann die Messspannung derart durch die Zusammensetzung des Frequenzgemisches geformt werden, dass diese Messspannung die Anforderungen an ein von dem Isolationsüberwachungsgerät zu erzeugendes Messsignal erfüllt und somit eine kontinuierliche Messung des Zweig-Isolationswiderstands und der Zweig-Ableitkapazität während der Isolationsüberwachung des Gesamtnetzes oder der Isolationsfehlersuche möglich ist.

In vorteilhafter Weise erfolgt das Erfassen des Differenzstroms mittels eines als Messstromwandler ausgeführten Stromsensors.

Die der Erfindung zugrundeliegende Aufgabe wird ebenfalls gelöst durch eine elektrische Schaltungsanordnung gemäß Anspruch 6.

Die beanspruchten strukturellen Merkmale der erfindungsgemäßen elektrischen Schaltungsanordnung führen die entsprechenden Verfahrensschritte des erfindungsgemäßen Verfahrens zur Bestimmung des Zweig-Isolationswiderstands und der Zweig-Ableitkapazität aus.

Somit treffen die mit dem Verfahren erzielten technischen Wirkungen und die daraus resultierenden Vorteile gleichermaßen auch auf die elektrische Schaltungsanordnung zu.

Weitere vorteilhafte Ausgestaltungsmerkmale ergeben sich aus der nachfolgenden Beschreibung und den Zeichnungen, die eine bevorzugte Ausführungsform der Erfindung anhand von Beispielen erläutern.

Es zeigen:
- **Fig. 1**: ein verzweigtes, ungeerdetes Stromversorgungssystem mit erfindungsgemäßer elektrischen Schaltungsanordnung,
- **Fig. 2**: einen Verlauf der Messspannung und
- **Fig. 3**: ein Ersatzschaltbild zur Berechnungen des Zweig-Isolationswiderstands und der Zweig-Ableitkapazität.

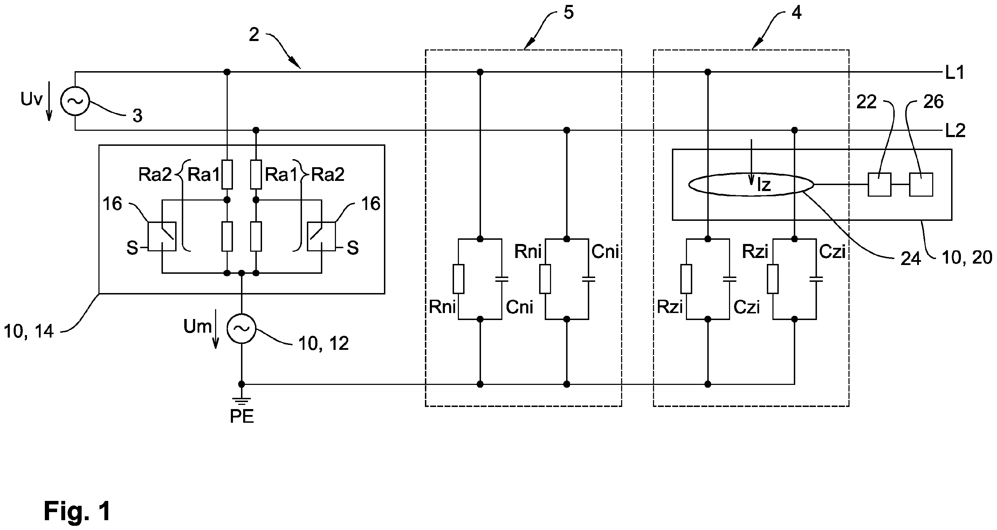

**Fig. 1** zeigt ein verzweigtes, ungeerdetes Stromversorgungssystem 2 mit einer erfindungsgemäßen elektrischen Schaltungsanordnung 10. Die elektrische Schaltungsanordnung 10 ist beispielhaft in der Anwendungsumgebung eines - nicht zur Erfindung gehörenden - einphasigen, ungeerdeten Wechselspannungsstromversorgungssystems 2 mit den aktiven Leitern L1 und L2 dargestellt. Ebenso kann das verzweigte, ungeerdete Stromversorgungssystem 2 als weitere Anwendungsumgebung auch ein mehrphasiges Wechselspannungs-Stromversorgungssystem oder ein Gleichspannungs-Stromversorgungssystem sein.

Das Stromversorgungssystem 2 ist in der Darstellung unterteilt in einen zu überwachenden Leitungszweig 4 und in ein Rest-Stromversorgungssystem 5 (Hauptsystem mit weiteren Leitungszweigen ohne den betrachten Leitungszweig 4).

Jeder aktive Leiter L1, L2 des zu überwachenden Leitungszweiges 4 weist gegenüber Erde PE einen Teil-Isolationswiderstand Rzi und eine Teil-Ableitkapazität Czi auf.

Das Rest-Stromversorgungssystem 5 besitzt die Teil-Isolationswiderstände Rni und die Teil-Ableitkapazitäten Cni gegenüber Erde PE.

Gespeist wird das Stromversorgungssystem 2 von einer Stromquelle 3 mit der Versorgungsspannung Uv.

Die erfindungsgemäße Schaltungsanordnung 10 besteht aus einer steuerbaren Messspannungsquelle 12 und einer Ankoppelschaltung 14, welche an zentraler Stelle das Stromversorgungssystem 2 mit einer Messspannung Um beaufschlagen, sowie aus einem in dem zu überwachenden Leitungszweig 4 angeordneten Stromsensor 20.

Die Ankoppelschaltung 14 ist mittels einer Schalteinheit 16 - hier in symmetrische Ankopplung separat für jeden aktiven Leiter L1, L2 dargestellt - umschaltbar ausgeführt, sodass bei Ansteuerung der Schalteinheit 16 über eine Steuerleitung S entweder ein erster Ankoppelwiderstand Ra1 oder ein zweiter Ankoppelwiderstand Ra2 synchron auf die aktiven Leiter L1, L2 geschaltet werden kann. In diesem Ausführungsbeispiel wird der zweite Ankoppelwiderstand Ra2 durch Reihenschaltung (Summenbildung) des ersten Ankoppelwiderstands Ra1 mit einem weiteren Widerstand gebildet.

In dem zu überwachenden Leitungszweig 4 ist ein Stromsensor 20 angeordnet, welcher den zur Messspannung Um proportionalen Differenzstrom Iz erfasst und auswertet. Dazu weist der Stromsensor 20 eine Recheneinheit 22 und einen Datenspeicher 26 auf. Bevorzugt ist der Stromsensor 20 als Messstromwandler 24 (Stromtransformator mit Ringkern) ausgebildet.

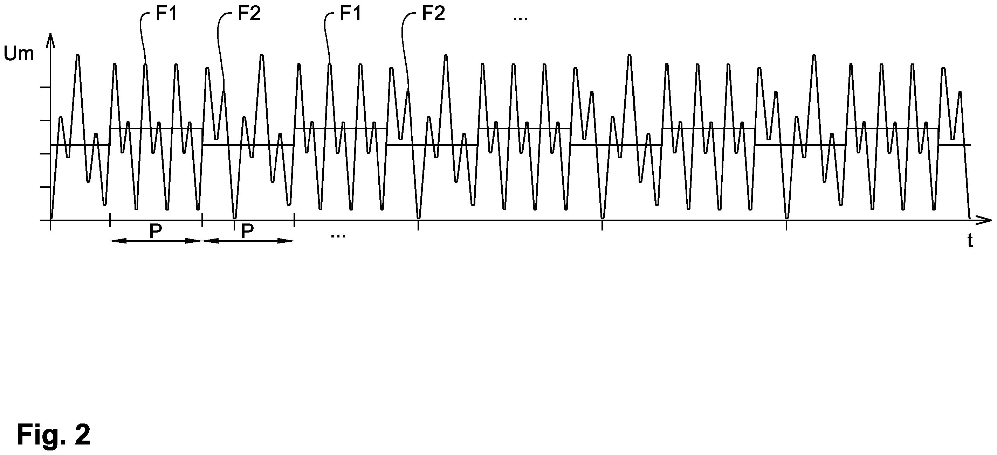

**Fig. 2** zeigt einen Verlauf der Messspannung Um.

Jeweils alternierend über eine Generatorperiode P werden das erste Frequenzgemisch F1 und in der darauffolgenden Generatorperiode P das zweite Frequenzgemisch F2 erzeugt, wobei das erzeugte erste Frequenzgemisch F1 über den ersten Ankoppelwiderstand Ra1 und das zweite Frequenzgemisch F2 über den zweiten Ankoppelwiderstand Ra2 zentral in das Stromversorgungssystem 2 eingespeist werden.

Beispielhaft sind das erste Frequenzgemisch F1 und das zweite Frequenzgemisch F2 jeweils aus zwei Frequenzanteilen überlagert dargestellt, wobei sich das erste Frequenzgemisch F1 von dem zweiten Frequenzgemisch F2 in mindestens einer Frequenz unterscheidet.

Die Perioden der in dem Frequenzgemischen F1 und F2 enthaltenen Frequenzen sind derart gewählt, dass sie als ganzzahliges Vielfaches in eine Generatorperiode P passen. Die Messspannung Um ist in Form des ersten Frequenzgemischs F1 für die Dauer einer Generatorperiode P über Ra1 an das Stromversorgungssystem 2 angekoppelt. Nach Ende dieser Generatorperiode P schaltet die Schalteinheit 16 auf den Wert des zweiten Ankoppelwiderstands Ra2 und das Frequenzgemisch F2 wird als Messspannung Um für die Dauer der darauffolgenden Generatorperiode P angelegt.

Die Länge der Generatorperiode P ist vorteilhafterweise an die Netzparameter des Stromversorgungssystems 2 (Gesamt-Isolationswiderstand, Gesamt-Ableitkapazität) angepasst, wobei die Perioden der in den Frequenzgemischen F1 und F2 enthaltenen Frequenzen entsprechend mitskaliert werden können.

Der in dem zu überwachenden Leitungszweig 4 von dem Stromsensor 20 erfasste Differenzstrom Iz wird in der Recheneinheit 22 in Verbindung mit dem Datenspeicher 26 ausgewertet. Dazu führt die Recheneinheit 22 eine Frequenzanalyse des Differenzstroms Iz, beispielsweise auf Basis einer Fourier-Transformation, über zwei aufeinander folgende Generatorperioden P durch, um daraus zu bestimmen, welches Frequenzgemisch F1, F2 während der jeweiligen Generatorperiode P aktuell eingespeist wird. Aus der dem Stromsensor 20 bekannten Zuordnung des erkannten Frequenzgemischs F1, F2 zu dem jeweiligen Ankoppelwiderstand Ra1, Ra2 wird somit der aktuell geschaltete Ankoppelwiderstand - erster Ankoppelwiderstand Ra1 oder zweiter Ankoppelwiderstand Ra2 - ermittelt.

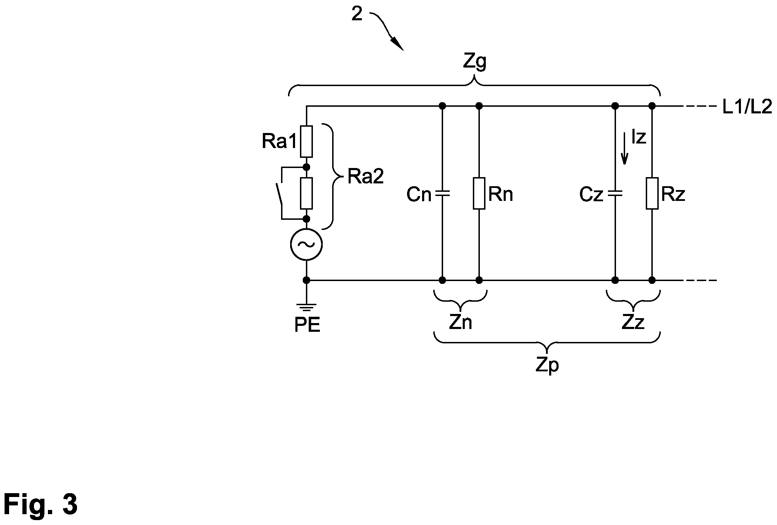

**Fig. 3** zeigt ein Ersatzschaltbild zur Berechnung des Zweig-Isolationswiderstandes Rz und der Zweig-Ableitkapazität Cz.

Dazu sind die in Fig. 1 dargestellten Teil-Isolationswiderstände Rzi und die Teil-Ableitkapazitäten Czi der einzelnen aktiven Leiter L1, L2 des zu überwachenden Leitungszweigs 4 zu einem Zweig-Isolationswiderstand Rz und einer Zweig-Ableitkapazität Cz vereinfachend zusammengefasst. In gleicher Weise sind die Teil-Isolationswiderstände Rni und die Teil-Ableitkapazitäten Cni des Rest-Stromversorgungssystems 5 zu dem Rest-Isolationswiderstand Rn und der Rest-Ableitkapazität Cn sowie die Ankoppelwiderstände zusammengefasst.

Der komplexe Widerstand (Impedanz) Zz des zu überwachenden Leitungszweiges 4 ergibt sich aus der Parallelschaltung des Zweig-Isolationswiderstands Rz und der Zweig-Ableitkapazität Cz.

Ebenso ergibt sich die Impedanz Zn des Rest-Stromversorgungssystems 5 aus der Parallelschaltung des Rest-Isolationswiderstandes Rn und der Rest-Ableitkapazität Cn.

Mit den in linearen Netzwerken geltenden Gesetzmäßigkeiten sowie unter der Anwendung der kirchhoffschen Regeln lässt sich ein Gleichungssystem für die vier unbekannten Größen Rest-Isolationswiderstand Rn, Zweig-Isolationswiderstand Rz sowie für die Rest-Ableitkapazität Cn und die Zweig-Ableitkapazität Cz aufstellen. Dabei wird der Differenzstrom Iz von dem Stromsensor 20 gemessen, wohingegen die Messspannung Um, deren Frequenzzusammensetzung und der jeweils aktiv geschaltete erste und zweite Ankoppelwiderstand Ra1, Ra2 dem Stromsensor 20 durch Konfiguration bekannt sind.

Dieses Gleichungssystem ist mit vier Kombinationen, gebildet aus dem ersten Ankoppelwiderstand Ra1, dem zweiten Ankoppelwiderstand Ra2 sowie für zwei bekannte, in den Frequenzgemischen F1, F2 enthaltenen Frequenzen ω1, ω2 lösbar.

Um eine zuverlässigere Zuordnung der Frequenzgemische F1, F2 zu den Ankoppelwiderständen Ra1, Ra2 zu erhalten, kann es vorteilhaft sein, mehr als die zwei notwendigen Frequenzen ω1, ω2 einzusetzen.

Aus dem Gleichungssystem lassen sich analytisch die Größen Rest-Isolationswiderstand Rn und Rest-Ableitkapazität Cn sowie insbesondere der gesuchte Zweig-Isolationswiderstand Rz und die gesuchte Zweig-Ableitkapazität Cz ermitteln.

## Patentansprüche

1. Verfahren zur Bestimmung eines Zweig-Isolationswiderstands (Rz) und einer Zweig-Ableitkapazität (Cz) eines zu überwachenden Leitungszweigs (4) in einem verzweigten, ungeerdeten Stromversorgungssystem (2) mit aktiven Leitern (L1, L2), umfassend die Verfahrensschritte:
Erzeugen einer Messspannung (Um) mittels einer steuerbaren Messspannungsquelle (12),
Einspeisen der Messspannung (Um) an zentraler Stelle des Stromversorgungssystems(2) mittels einer Ankoppelschaltung (14) jeweils in die aktiven Leiter (L1, L2),
Erfassen eines durch die Messspannung (Um) bewirkten Differenzstroms (Iz) in dem zu überwachenden Leitungszweig (4) mittels eines Stromsensors (20),
**dadurch gekennzeichnet, dass**
die Messspannung (Um) alternierend über jeweils eine Generatorperiode (P) aus einem ersten Frequenzgemisch (F1) und einem zweiten Frequenzgemisch (F2) geformt wird,
das Einspeisen des ersten Frequenzgemischs (F1) mittels einer mit einer Schalteinheit (16) umschaltbaren Ankoppelschaltung (14) über einen ersten Ankoppelwiderstand (Ra1) und das Einspeisen des zweiten Frequenzgemischs (F2) über einen zweiten Ankoppelwiderstand (Ra2) erfolgt,
in einem Datenspeicher (26) des Stromsensors (20) der Wert des ersten Ankoppelwiderstands (Ra1) und der Wert des zweiten Ankoppelwiderstands (Ra2) sowie die spektrale Zusammensetzung des ersten Frequenzgemischs (F1) und die spektrale Zusammensetzung des zweiten Frequenzgemischs (F2) hinterlegt sind,
der Stromsensor (20) in einer Recheneinheit (22) eine Frequenzanalyse des Differenzstroms (Iz) über zwei aufeinanderfolgende Generatorperioden (P) durchführt, um zu erkennen, welches Frequenzgemisch (F1, F2) aktuell eingespeist wird,
der aktuell geschaltete Ankoppelwiderstand (Ra1, Ra2) aus der Zuordnung des erkannten Frequenzgemischs (F1, F2) zu dem jeweiligen Ankoppelwiderstand (Ra1, Ra2) in der Recheneinheit (22) bestimmt wird,
aus dem gemessenen Differenzstrom (Iz), der Messspannung (Um),
den in dem Frequenzgemisch (F1, F2) enthaltenen Frequenzen (ω1, ω2) und dem Ankoppelwiderstand (Ra1, Ra2) der Zweig-Isolationswiderstand (Rz) und die Zweig-Ableitkapazität (Cz) in der Recheneinheit berechnet werden.

2. Verfahren nach Anspruch 1,
**dadurch gekennzeichnet,**
**dass** das erste Frequenzgemisch (F1) und das zweite Frequenzgemisch (F2) jeweils mindestens zwei Frequenzen (ω1, ω2) enthalten, wobei sich das erste Frequenzgemisch (F1) von dem zweiten Frequenzgemisch (F2) in mindestens einer Frequenz unterscheidet.

3. Verfahren nach Anspruch 1 oder 2,
**dadurch gekennzeichnet,**
**dass** die in den Frequenzgemischen (F1, F2) enthaltenen Frequenzen so gewählt werden, dass deren Perioden als ganzzahliges Vielfaches in der Generatorperiode (P) enthalten sind.

4. Verfahren nach einem der Ansprüche 1 bis 3,
**dadurch gekennzeichnet,**
**dass** die Messspannung (Um) eine Messimpuls-Spannung eines Isolationsüberwachungsgerätes oder eine Prüfspannung einer Isolationsfehler-Sucheinrichtung ist.

5. Verfahren nach einem der Ansprüche 1 bis 4,
**dadurch gekennzeichnet,**
**dass** das Erfassen des Differenzstroms (Iz) mittels eines als Messstromwandler ausgeführten Stromsensors erfolgt.

6. Elektrische Schaltungsanordnung (10) zur Bestimmung eines Zweig-Isolationswiderstands (Rz) und einer Zweig-Ableitkapazität (Cz) eines zu überwachenden Leitungszweigs (4) in einem verzweigten, ungeerdeten Stromversorgungssystem (2) mit aktiven Leitern (L1, L2), bestehend aus
einer steuerbaren Messspannungsquelle (12) zum Erzeugen einer Messspannung (Um),
einer Ankoppelschaltung (14) zum Einspeisen der Messspannung (Um) an zentraler Stelle des Stromversorgungssystems (2) jeweils in die aktiven Leiter (L1, L2),
einem Stromsensor (20) zum Erfassen eines durch die Messspannung (Um) bewirkten Differenzstroms (Iz) in dem zu überwachenden Leitungszweig (4),
**dadurch gekennzeichnet, dass**
die steuerbare Messspannungsquelle (12) ausgelegt ist zur Formung der Messspannung (Um) mit einem ersten Frequenzgemisch (F1) und mit einem zweiten Frequenzgemisch (F2) jeweils alternierend über eine Generatorperiode (P),
die Ankoppelschaltung (14) mittels einer Schalteinheit (16) umschaltbar ausgeführt ist und einen ersten Ankoppelwiderstand (Ra1) zum Einspeisen des ersten Frequenzgemischs (F1) und einen zweiten Ankoppelwiderstand (Ra2) zum Einspeisen des zweiten Frequenzgemischs (F2) aufweist,
der Stromsensor (20) einen Datenspeicher (26) aufweist, in dem der Wert des ersten Ankoppelwiderstands (Ra1) und der Wert des zweiten Ankoppelwiderstands (Ra2) sowie die spektrale Zusammensetzung des ersten Frequenzgemischs (F1) und die spektrale Zusammensetzung des zweiten Frequenzgemischs (F2) hinterlegt sind,
der Stromsensor eine Recheneinheit (22) aufweist, die konfiguriert ist
zum Durchführen einer Frequenzanalyse des Differenzstroms (Iz) über zwei aufeinanderfolgende Generatorperioden (P), um zu erkennen, welches Frequenzgemisch (F1, F2) aktuell eingespeist wird, zum Bestimmen des aktuell geschalteten Ankoppelwiderstands (Ra1, Ra2) aus der Zuordnung des erkannten Frequenzgemischs (F1, F2) zu dem jeweiligen Ankoppelwiderstand (Ra1, Ra2) und
zum Berechnen des Zweig-Isolationswiderstands (Rz) und der Zweig-Ableitkapazität (Cz) aus dem gemessenen Differenzstrom (Iz), der Messspannung (Um), den in dem Frequenzgemisch (F1, F2) enthaltenen Frequenzen (ω1, ω2) und dem Ankoppelwiderstand (Ra1, Ra2).

7. Elektrische Schaltungsanordnung (10) nach Anspruch 6,
**dadurch gekennzeichnet,**
**dass** die steuerbare Messspannungsquelle (12) so konfiguriert ist, dass das erste Frequenzgemisch (F1) und das zweite Frequenzgemisch (F2) jeweils mindestens zwei Frequenzen enthalten, wobei sich das erste Frequenzgemisch (F1) von dem zweiten Frequenzgemisch (F2) in mindestens einer Frequenz unterscheidet.

8. Elektrische Schaltungsanordnung (10) nach Anspruch 6 oder 7,
**dadurch gekennzeichnet,**
**dass** die steuerbare Messspannungsquelle (12) so konfiguriert ist, dass die in den Frequenzgemischen (F1, F2) enthaltenen Frequenzen so gewählt werden, dass deren Perioden als ganzzahliges Vielfaches in der Generatorperiode (P) enthalten sind.

9. Elektrische Schaltungsanordnung (10) nach einem der Ansprüche 6 bis 8,
**dadurch gekennzeichnet,**
**dass** die steuerbare Messspannungsquelle (12) eine Messimpuls-Spannungsquelle eines Isolationsüberwachungsgerätes oder eine Prüfspannungsquelle einer Isolationsfehler-Sucheinrichtung ist.

10. Elektrische Schaltungsanordnung nach einem der Ansprüche 6 bis 9, **dadurch gekennzeichnet,**
**dass** der Stromsensor (20) als Messstromwandler (24) ausgeführt ist.

## Claims

1. A method for determining a branch insulation resistance (Rz) and a branch leakage capacitance (Cz) of a line branch (4) to be monitored in a branched, ungrounded power supply system (2) having active conductors (L1, L2), the method comprising the following steps:
generating a measuring voltage (Um) by means of a controllable measuring voltage source (12);
feeding the measuring voltage (Um) in each active conductor (L1, L2) at a central location of the power supply system (2) by means of a coupling circuit (14);
registering, by means of a current sensor (20), a residual current (Iz) caused by the measuring voltage (Um) in the line branch (4) to be monitored,
**characterized in that**
the measuring voltage (Um) is formed alternatingly via a generator period (P) from a first frequency composition (F1) and a second frequency composition (F2), respectively,
the first frequency composition (F1) is fed via a first coupling resistance (Ra1) by means of a coupling circuit (14) switchable using a switching unit (16) and the second frequency composition (F2) is fed via a second coupling resistance (Ra2);
the value of the first coupling resistance (Ra1) and the value of the second coupling resistance (Ra2) and the spectral composition of the first frequency composition (F1) and the spectral composition of the second frequency composition (F2) are stored in a data storage (26) of the current sensor (20);
the current sensor (20) executes a frequency analysis of the residual current (Iz) in a computing unit (22) over two subsequent generator periods (P) in order to identify which frequency composition (F1, F2) is fed presently;
the coupling resistance (Ra1, Ra2) presently switched is determined from the assignment of the identified frequency composition (F1, F2) to the corresponding coupling resistance (Ra1, Ra2) in the computing unit (22);
the branch insulation resistance (Rz) and the branch leakage capacitance (Cz) are computed in the computing unit from the measured residual current (Iz), the measuring voltage (Um), the frequencies (ω1, ω2) contained in the frequency composition (F1, F2), and the coupling resistance (Ra1, Ra2).

2. The method according to claim 1,
**characterized in that**
the first frequency composition (F1) and the second frequency composition (F2) each contain at least two frequencies (ω1, ω2), the first frequency composition (F1) differing from the second frequency composition (F2) in at least one frequency.

3. The method according to claim 1 or 2,
**characterized in that**
the frequencies contained in the frequency compositions (F1, F2) are chosen such that their periods are contained as integral multiples in the generator period (P).

4. The method according any one of the claims 1 to 3,
characterized din that
the measuring voltage (Um) is a measuring-pulse voltage of an insulation monitoring device or a test voltage of an insulation fault location device.

5. The method according to any one of the claims 1 to 4, **characterized in that**
the residual current (Iz) is registered by means of a current sensor configured as a measuring-current transformer.

6. An electric circuit arrangement (10) for determining a branch insulation resistance (Rz) and a branch leakage capacitance (Cz) of a line branch to be monitored (4) in a branched, ungrounded power supply system (2) having active conductors (L1, L2), the circuit arrangement consisting of
a controllable measuring voltage source (12) for generating a measuring voltage (Um),
a coupling circuit (14) for feeding the measuring voltage (Um) in each of the active conductors (L1, L2) at a central location of the power supply system (2),
a current sensor (20) for registering a residual current (Iz) caused by the measuring voltage (Um) in the line branch (4) to be monitored,
**characterized in that**
the controllable measuring voltage source (12) is configured for alternatingly forming the measuring voltage (Um) having a first frequency composition (F1) and having a second frequency composition (F2) over a generator period (P),
the coupling circuit (14) is designed to be switchable by means of a switch unit (16) and has a first coupling resistance (Ra1) for supplying the first frequency composition (F1) and a second coupling resistance (Ra2) for supplying the second frequency composition (F2),
the current sensor (20) has a data storage (26), in which the value of the first coupling resistance (Ra1) and the value of the second coupling resistance (Ra2) and the spectral composition of the first frequency composition (F1) and the spectral composition of the second frequency composition (F2) are stored,
the current sensor (20) has a computing unit (22), which is configured
to execute a frequency analysis of the residual current (Iz) over two subsequent generator periods (P) in order to identify which frequency composition (F1, F2) is presently fed,
to determine the presently switched coupling resistance (Ra1, Ra2) from the assignment of the identified frequency composition (F1, F2) to the corresponding coupling resistance (Ra1, Ra2), and to compute the branch insulation resistance (Rz) and the branch leakage capacitance (Cz) from the measured residual current (Iz), the measuring voltage (Um), the frequencies (ω1, ω2) contained in the frequency composition (F1, F2) and the coupling resistance (R1, R2).

7. The electric circuit arrangement (10) according to claim 6, **characterized in that**
the controllable measuring voltage source (12) is configured such that the first frequency composition (F1) and the second frequency composition (F2) each contain at least two frequencies, the first frequency composition (F1) differing from the second frequency composition (F2) in at least one frequency.

8. The electric circuit arrangement (10) according to claim 6 or 7, **characterized in that**
the controllable measuring voltage source is configured such that the frequencies contained in the frequency compositions (F1, F2) are chosen such that their periods are contained as integral multiples in the generator period (P).

9. The electric circuit arrangement (10) according to claim 6 to 8, **characterized in that**
the controllable measuring voltage source (12) is a measuring-pulse voltage source of an insulation monitoring device or a test voltage source of an insulation-fault location device.

10. The electric circuit arrangement according to any one of the claims 6 to 9,
**characterized in that**
the current sensor (20) is designed as a measuring current transformer (24).

## Revendications

1. Procédé pour la détermination d'une résistance (Rz) d'isolement de branche et d'une capacité (Cz) de fuite de branche d'une branche de ligne (4) à surveiller dans un système (2) d'alimentation en courant ramifié, non mis à la terre et ayant des conducteurs actifs (L1, L2), le procédé comprenant les étapes suivantes :
la génération d'une tension de mesure (Um) au moyen d'une source contrôlable (12) de tension de mesure ;
l'alimentation en tension de mesure (Um) à chaque conducteur actif (L1, L2) à une position centrale du system (2) d'alimentation en courant au moyen d'un circuit de couplage (14) ;
l'enregistrement, au moyen d'un capteur de courant (20), d'un courant résiduel (Iz) causé par la tension de mesure (Um) dans la branche de ligne (4) à surveiller,
**caractérisé en ce que**
la tension de mesure (Um) est formée de manière alternant via une période de générateur (P) à partir d'une première composition de fréquence (F1) et d'une deuxième composition de fréquence (F2), respectivement,
la première composition de fréquence (F1) est fournie par une première résistance de couplage (Ra1) au moyen d'un circuit de couplage (14) commutable à l'aide d'une unité de commutation (16) et la deuxième composition de fréquence (F2) est fournie par une deuxième résistance de couplage (Ra2) ;
la valeur de la première résistance de couplage (Ra1) et la valeur de la deuxième résistance de couplage (Ra2) ainsi que la composition spectrale de la première composition de fréquence (F1) et la composition spectrale de la deuxième composition de fréquence (F2) sont stockées dans une mémoire de données (26) du capteur de courant (20) ;
le capteur de courant (20) exécute une analyse de fréquence du courant résiduel (Iz) dans une unité de calcul (22) sur deux périodes de générateur (P) consécutives afin d'identifier quelle composition de fréquence (F1, F2) est fournie actuellement ;
la résistance de couplage (Ra1, Ra2) actuellement commutée est déterminée à partir de l'affectation de la composition de fréquence (F1, F2) identifiée à la résistance de couplage (Ra1, Ra2) correspondante dans l'unité de calcul (22) ;
la résistance (Rz) d'isolement de branche et la capacité (Cz) de fuite de branche sont calculées dans l'unité de calcul à partir du courant résiduel (Iz) mesuré, de la tension de mesure (Um), des fréquences (ω1, ω2) contenues dans la composition de fréquence (F1, F2) et de la résistance de couplage (Ra1, Ra2).

2. Procédé selon la revendication 1,
**caractérisé en ce que**
la première composition de fréquence (F1) et la deuxième composition de fréquence (F2) contiennent chacune au moins deux fréquences (ω1, ω2), la première composition de fréquence (F1) différant de la deuxième composition de fréquence (F2) par au moins une fréquence.

3. Procédé selon la revendication 1 ou la revendication 2, **caractérisé en ce que**
les fréquences contenues dans les compositions de fréquence (F1, F2) sont choisies de telle sorte que leurs périodes sont contenues comme multiples entiers dans la période de générateur (P).

4. Procédé selon l'une quelconque des revendications 1 à 3, **caractérisé par le fait que**
la tension de mesure (Um) est une tension de l'impulsion de mesure d'un dispositif de surveillance d'isolement ou une tension d'essai d'un dispositif de localisation de faute d'isolement.

5. Procédé selon l'une quelconque des revendications 1 à 4, **caractérisé en ce que**
le courant résiduel (Iz) est enregistré au moyen d'un capteur de courant configuré comme transformateur du courant de mesure.

6. Ensemble de circuit (10) électrique pour la détermination d'une résistance (Rz) d'isolement de branche et d'une capacité (Cz) de fuite d'une branche de ligne (4) à surveiller dans un système (2) d'alimentation en courant ramifié, non mis à la terre et ayant des conducteurs actifs (L1, L2), l'ensemble de circuit consistant en une source contrôlable (12) de tension de mesure pour générer une tension de mesure (Um),
en un circuit de couplage (14) pour fournir la tension de mesure (Um) dans chacun des conducteurs actifs (L1, L2) à une position centrale du système (2) d'alimentation en courant,
en un capteur de courant (20) pour enregistrer un courant résiduel (Iz) causé par la tension de mesure (Um) dans la branche de ligne (4) à surveiller,
**caractérisé en ce que**
la source contrôlable (12) de tension de mesure est configurée pour former de manière alternant la tension de mesure (Um) ayant une première composition de fréquence (F1) et ayant une deuxième composition de fréquence (F2) sur une période de générateur (P), le circuit de couplage (14) est conçu pour être commuté au moyen d'une unité de commutation (16) et a une première résistance de couplage (Ra1) pour fournir la première composition de fréquence (F1) et une deuxième résistance de couplage (Ra2) pour fournir la deuxième composition de fréquence (F2),
le capteur de courant (20) a une mémoire de données (26), dans lequel sont stockées la valeur de la première résistance de couplage (Ra1) et la valeur de la deuxième résistance de couplage (Ra2) ainsi que la composition spectrale de la première composition de fréquence (F1) et la composition spectrale de la deuxième composition de fréquence (F2),
le capteur de courant (20) a une unité de calcul (22), qui est configurée
pour exécuter une analyse de fréquence du courant résiduel (Iz) sur deux périodes de générateur (P) consécutives afin d'identifier quelle composition de fréquence (F1, F2) est actuellement fournie, pour déterminer la résistance de couplage (Ra1, Ra2) actuellement commutée à partir de l'affectation de la composition de fréquence (F1, F2) identifiée à la résistance de couplage (Ra1, Ra2) correspondante, et
pour calculer la résistance (Rz) d'isolement de branche et la capacité (Cz) de fuite de branche à partir du courant résiduel (Iz) mesuré, de la tension de mesure (Um), des fréquences (ω1, ω2) contenues dans la composition de fréquence (F1, F2) et de la résistance de couplage (R1, R2).

7. Ensemble de circuit (10) électrique selon la revendication 6, **caractérisé en ce que**
la source contrôlable (12) de tension de mesure est configurée de telle sorte que la première composition de fréquence (F1) et la deuxième composition de fréquence (F2) contiennent chacune au moins deux fréquences, la première composition de fréquence (F1) différant de la deuxième composition de fréquence (F2) par au moins une fréquence.

8. Ensemble de circuit (10) électrique selon la revendication 6 ou la revendication 7,
**caractérisé en ce que**
la source contrôlable (12) de tension de mesure est configurée de telle sorte que les fréquences contenues dans la composition de fréquences (F1, F2) sont choisies de telle sorte que leurs périodes sont contenues comme multiples entiers dans la période de générateur (P).

9. Ensemble de circuit (10) électrique selon l'une quelconque des revendications 6 à 8,
**caractérisé en ce que**
la source contrôlable (12) de tension de mesure est une source de tension de l'impulsion de mesure d'un dispositif de surveillance d'isolement ou une source de tension d'essai d'un dispositif de localisation de défauts d'isolement.

10. Ensemble de circuit (10) électrique selon l'une quelconque des revendications 6 à 9,
**caractérisé en ce que**
le capteur de courant (20) est réalisé comme transformateur (24) de courant de mesure.
